# EUROPEAN PATENT APPLICATION

(11) **EP 4 439 666 A2**
(43) Date of publication of application: **02.10.2024**
(21) Application number: 24165765.9
(22) Date of filing: 25.03.2024
(51) Int. Cl.: H01L 25/10, H01L 25/16, H01L 23/31, H01L 25/065

(54) **SEMICONDUCTOR DEVICE**

(30) Priority: 27.03.2023 US 202363492257 P; 10.05.2023 US 202363501155 P; 05.01.2024 US 202418405195
(71) Applicant: MediaTek Inc., 30078 Hsinchu City (TW)
(72) Inventor: KUO, Che-Hung, 30078 Hsinchu City (TW); YU, Ta-Jen, 30078 Hsinchu City (TW); HUANG, Chi-Hung, 30078 Hsinchu City (TW)
(74) Representative: Haseltine Lake Kempner LLP

(57) **Abstract**

A semiconductor device is provided. The semiconductor device includes a bottom package (300A) and a top package (400). The top package is mounted on the bottom package. At least one portion (400EP) of the top package protrudes from a sidewall of the bottom package. The semiconductor device further includes a passive device mounted on a protruding region of the portion of the top package.

## Description

This application claims the benefit of U.S. Provisional Application No. 63/492,257, filed on March 27, 2023, and U.S. Provisional Application No. 63/501,155, filed May 10, 2023, the entirety of which are incorporated by reference herein.

### BACKGROUND OF THE DISCLOSURE

### Field of the Disclosure

The present disclosure relates to a semiconductor device, and, in particular, to a package-on-package (PoP) semiconductor package.

### Description of the Related Art

As demand increases for smaller devices with more functionality, package-on-package (PoP) technology has become increasingly popular. PoP technology vertically stacks two or more packages and minimizes the track lengths between different components, such as a controller and a memory device. This provides better electrical performance, since shorter routing of interconnections yields faster signal propagation with reduced noise and cross-talk defects.

Although existing semiconductor packages are generally adequate, they are not satisfactory in every respect. For example, it is a challenge to fulfill the high-speed memory package requirements while maintaining the size and fabrication cost of the logic package. Therefore, there is a need to further improve semiconductor packages to provide flexibility in structural design.

### BRIEF SUMMARY OF THE DISCLOSURE

An embodiment of the present disclosure provides a semiconductor device. The semiconductor device includes a bottom package and a top package. The top package is mounted on the bottom package. At least one portion of the top package protrudes from a sidewall of the bottom package.

In some embodiments, the top package is mounted on the bottom package using first conductive elements. In some embodiments, the first conductive elements overlap the bottom package. In some embodiments, a distance of the portion protruding from the sidewall of the bottom package is greater than 0 mm and less than or equal to 5 mm. In some embodiments, the top package completely covers the bottom package in a top view. In some embodiments, one edge of the top package is flush with the corresponding sidewall of the bottom package. In some embodiments, two or three edges of the top package are flush with the corresponding sidewalls of the bottom package. In some embodiments, the top package partially covers the bottom package in a top view. In some embodiments, a first portion of the bottom package is exposed from the top package in a top view.

In some embodiments, the semiconductor device further includes a passive device mounted on a protruding region of the portion of the top package. In some embodiments, the passive device and the bottom package are arranged side-by-side and disposed on the same side of the top package. In some embodiments, the passive device and the bottom package are electrically connected to the top package by different conductive elements. In some embodiments, in a top view, the bottom package has a first area and the top package has a second area greater than the first area, and wherein a ratio of the difference between the first and second area to the first area is greater than 0 and less than or equal to 0.56. In some embodiments, the bottom package includes a multi-die package. In some embodiments, the bottom package includes a routing structure located between a first semiconductor die of the bottom package and the top package. In some embodiments, the semiconductor device is a high bandwidth package-on-package (HBPoP) package or a fan-out package-on-package (fan-out PoP) package. In some embodiments, the top package is mounted on the bottom package by conductive elements. The conductive elements are in contact with the routing structure. In some embodiments, the bottom package comprises conductive interconnects surrounding at least one first semiconductor die of the bottom package. The conductive elements are in contact with the first conductive interconnects, respectively. In some embodiments, the bottom package includes a first molding compound covering the first semiconductor die, wherein the conductive interconnects pass through the first molding compound. In some embodiments, the top package includes a second semiconductor die and a second molding compound. The second molding compound covers the first semiconductor die and separated from the first molding compound by the conductive elements.

Another embodiment of the present disclosure provides a semiconductor device. The semiconductor device includes a bottom package and a top package. The top package is mounted on the bottom package. At least one edge of the top package extends outward beyond a respective sidewall of the bottom package.

In some embodiments, the at least one edge of the top package extends outward beyond the respective sidewall of the bottom package with a distance, wherein the distance is greater than 0 mm and less than or equal to 5 mm. In some embodiments, the top package partially covers the bottom package, or the top package completely covers the bottom package. In some embodiments, the bottom package has a first area and the top package has a second area greater than the first area, and wherein a ratio of the difference between the first and second areas to the first area is greater than 0 and less than or equal to 0.56. In some embodiments, the semiconductor device further includes a passive device mounted on an extending portion of the top package, wherein the passive device is disposed adjacent to the respective sidewall of the bottom package.

### BRIEF DESCRIPTION OF THE DRAWINGS

The present disclosure can be more fully understood by reading the subsequent detailed description and examples with references made to the accompanying drawings, wherein:
FIG. 1 is a cross-sectional view of a semiconductor device in accordance with some embodiments of the disclosure;
FIG. 2 is a perspective bottom view of a top package of the semiconductor device of FIG. 1 in accordance with some embodiments of the disclosure, showing the position of conductive structures of a top package stacked on a bottom package;
FIGS. 3, 4, 5 and 6 are plan views of the semiconductor device of FIG. 1 in accordance with some embodiments of the disclosure, showing the relative position between a top package stacked on a bottom package;
FIG. 7 is a cross-sectional view of a semiconductor device in accordance with some embodiments of the disclosure;
FIGS. 8 and 9 are plan views of the semiconductor device of FIG. 7 in accordance with some embodiments of the disclosure, showing the relative position between a top package stacked on a bottom package;
FIG. 10 is a cross-sectional view of a semiconductor device in accordance with some embodiments of the disclosure;
FIG. 11 is a cross-sectional view of a semiconductor device in accordance with some embodiments of the disclosure;
FIG. 12 is a cross-sectional view of a semiconductor device in accordance with some embodiments of the disclosure; and
FIG. 13 is a cross-sectional view of a semiconductor device in accordance with some embodiments of the disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

Among the advanced packaging technologies, high-end products usually adopt package-on-package (PoP) structure (e.g., a dynamic random access memory (DRAM) package is stacked on top of a system-on-chip (SOC) package) for high-speed double data rate (DDR) performance requests. Normally, the size of the bottom package (e.g., the SOC package) is bigger than or equal to that of the top package (e.g., the DRAM package). To fulfill high-speed DRAM requirements, the size of the DRAM package may be bigger than the size of current SOC package. As the size of the DRAM package increases, the size and fabrication cost of the bottom package (e.g., the SOC package) may increase accordingly to follow the conventional package-stack rule (bottom package size ≥ top package size). Thus, a novel package-on-package (PoP) structure is desirable.

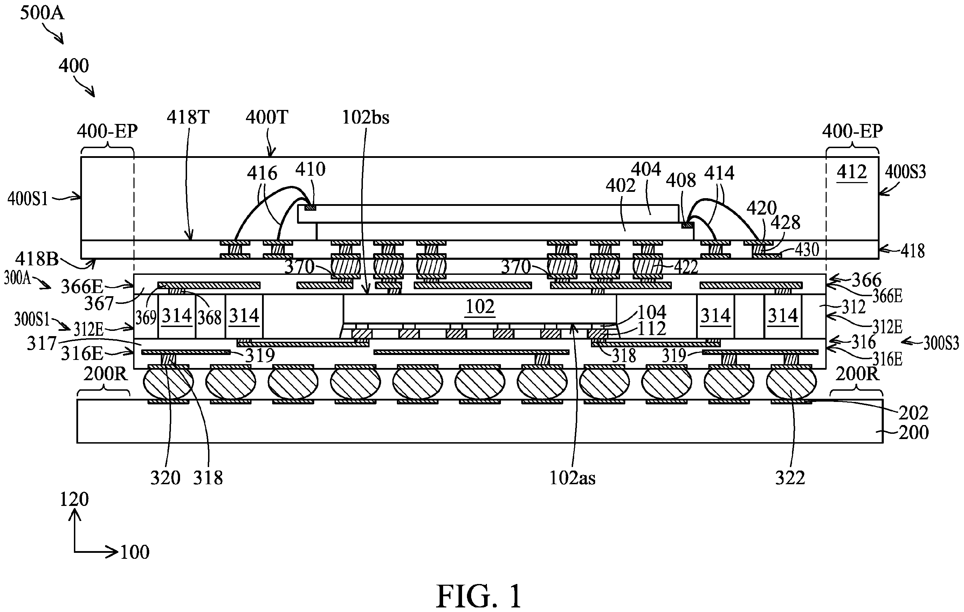

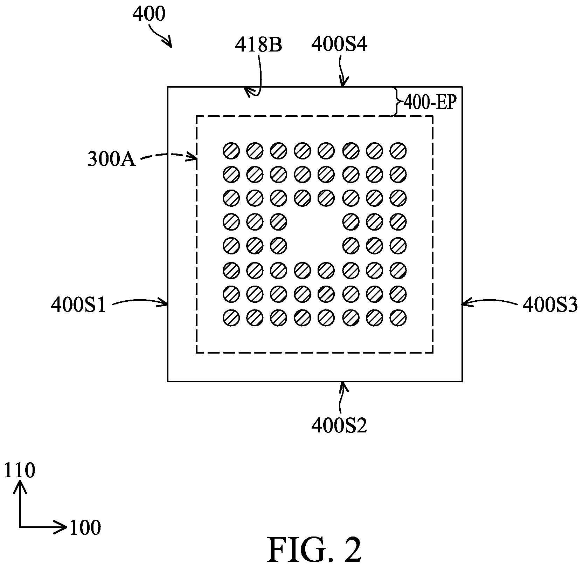

FIG. 1 is a cross-sectional view of a semiconductor device 500A in accordance with some embodiments of the disclosure. In some embodiments, the semiconductor device 500A is a three-dimensional (3D) package-on-package (PoP) semiconductor package including a high bandwidth package-on-package (HBPoP) package or a fan-out package-on-package (fan-out PoP) package. For example, the semiconductor device 500A may be a high bandwidth package-on-package (HBPoP) package. FIG. 2 is a perspective bottom view of the top package 400 of the semiconductor device 500A of FIG. 1 in accordance with some embodiments of the disclosure. The semiconductor device 500A may include at least two vertically stacked semiconductor packages mounted on a base 200. As shown in FIG. 1, in some embodiments, the semiconductor device 500A includes a bottom package 300A and the top package 400 vertically stacked on the bottom package 300A. In some embodiments, the bottom package 300A comprises a fan-out package such as a system-on-chip (SOC) package. Alternatively, the bottom package 300A may comprise a stacked-die package. The top package 400 comprises a memory package such as a dynamic random access memory (DRAM) package.

As shown in FIG. 1, the base 200, for example a printed circuit board (PCB), may be formed of polypropylene (PP), Pre-preg, FR-4 and/or other epoxy laminate material. It should also be noted that the base 200 can be a single layer or a multilayer structure. A plurality of pads 202 and/or conductive traces (not shown) is disposed on the base 200. In one embodiment, the conductive traces may comprise signal trace segments or ground trace segments, which are used for the input/output (I/O) connections of the bottom package 300 and the top package 400. Also, the bottom package 300A is mounted directly on the conductive traces. In some other embodiments, the pads 202 are disposed on the base 200, and the pads 202 are connected to different terminals of the conductive traces. The pads 202 are used for the bottom package 300A that is mounted directly on them.

As shown in FIG. 1, the bottom package 300A is mounted on the base 200 by a bonding process. The bottom package 300A is mounted on the base 200 using conductive elements 322. In some embodiments, the bottom package 300A is a three-dimensional (3D) semiconductor package including at least one semiconductor die 102, a front-side routing structure 316, a back-side routing structure 366, conductive interconnects 314 and the conductive elements 322.

The semiconductor die 102 has an active surface 102as and a backside surface 102bs opposite to the active surface 102as. In some embodiments, the semiconductor die 102 is fabricated by a flip-chip technology. The semiconductor die 102 may be flipped to be disposed on the front-side routing structure 316 opposite the conductive elements 322. In some embodiments, the semiconductor die 102 includes a system-on-chip (SOC) die, a logic device, a memory device, a radio frequency (RF) device, the like, or any combination thereof. For example, the semiconductor die 102 may include a micro control unit (MCU) die, a microprocessor unit (MPU) die, a power management integrated circuit (PMIC) die, a global positioning system (GPS) device, a central processing unit (CPU) die, a graphics processing unit (GPU) die, an input-output (IO) die, a dynamic random access memory (DRAM) IP core, a static random-access memory (SRAM), a high bandwidth memory (HBM), the like, or any combination thereof.

The front-side routing structure 316 is disposed on the active surface 102as of the semiconductor die 102. In addition, the front-side routing structure 316 is disposed between the semiconductor die 102 and the base 200 along the direction 120. Pads 104 on the active surface 102as of the semiconductor die 102 are electrically connected to the front-side routing structure 316 using conductive elements 112. In some embodiments, the conductive elements 112 include conductive materials, such as metal. The conductive elements 112 may include microbumps, controlled collapse chip connection (C4) bumps, ball grid array (BGA) balls, the like, or a combination thereof. In some embodiments, the front-side routing structure 316 includes an interposer, a redistribution layer (RDL) structure or a substrate. For example, the front-side routing structure 316 may be an interposer 316. As shown in FIG. 1, the front-side routing structure 316 may include one or more conductive traces 319, one or more vias 318 disposed in one or more dielectric layers 317 and contact pads 320. The conductive traces 319 are electrically connected to the corresponding contact pads 320. The contact pads 320 are exposed to openings of the solder mask layer (not shown) and close to the base 200. The conductive elements 322 are disposed on and in contact with the corresponding the contact pads 320. Therefore, the conductive elements 322 are electrically connected between the contact pads 320 of the semiconductor package 300A and the pads 202 of the base 200. The semiconductor die 102 is electrically connected to the base 200 using the vias 318, the conductive traces 319 and the contact pads 320 of the front-side routing structure 316 and the corresponding conductive elements 322. In some embodiments, the vias 318, the conductive traces 319 and the contact pads 320 include a conductive material, such as metals comprising copper, gold, silver, or other applicable metals. The dielectric layers 317 may include extra-low K (ELK) dielectrics and/or ultra-low K (ULK) dielectric. In addition, the dielectric layers 317 may include epoxy. However, it should be noted that the number of dielectric layers 317, that the number of vias 318, the number of conductive traces 319 and the number of contact pads 320 shown in FIG. 1 are only an example and are not a limitation to the present disclosure.

The conductive interconnects 314, such as through vias (TVs), interposer pillar or conductive ball structures, are disposed on the front-side routing structure 316 and beside the semiconductor die 102. As shown in FIG. 1, the conductive interconnects 314 are electrically connected to the vias 318, the conductive traces 319 and the contact pads 320 of the front-side routing structure 316. The conductive interconnects 314 may surround the semiconductor die 102 of the bottom package 300A. In addition, the conductive interconnects 314 may be electrically connected to the semiconductor die 102 using the vias 318 and the conductive traces 319 inside the front-side routing structure 316.

As shown in FIG. 1, the bottom package 300 further include a molding compound 312 disposed on and in contact with the front-side routing structure 316. The molding compound 312 covers and is in contact with the semiconductor die 102. In addition, the molding compound 312 surrounds and is in contact with the conductive interconnects 314. Furthermore, the conductive interconnects 314 may pass through the molding compound 312. The backside surface 102bs of the semiconductor die 102 may be cover by or exposed from the molding compound 312. In some embodiments, the molding compound 312 may be formed of a nonconductive material, such as an epoxy, a resin, a moldable polymer, or the like. The molding compound 312 may be applied while substantially liquid, and then may be cured through a chemical reaction, such as in an epoxy or resin. In some other embodiments, the molding compound 312 may be an ultraviolet (UV) or thermally cured polymer applied as a gel or malleable solid capable of being disposed around the semiconductor die 102, and then may be cured using a UV or thermally curing process. The molding compound 312 may be cured with a mold.

The back-side routing structure 366 is disposed on the backside surface 102bs of the semiconductor die 102. In addition, the back-side routing structure 366 is located between the semiconductor die 102 and the top package 400 along the direction 120, and the back-side routing structure 366 is electrically connected to the conductive interconnects 314. As shown in FIG. 1, the semiconductor die 102 is separated from the top package 400 by the back-side routing structure 366. The molding compound 312 fills a space (not shown) between the front-side routing structures 316 and the back-side routing structure 366, and the molding compound 312 adjoins sidewalls of the semiconductor die 102, and the molding compound 312 is also adjacent to surfaces of the front-side routing structures 316 and surfaces of the back-side routing structure 366. The front-side routing structures 316 and the back-side routing structure 366 are in contact with respective opposite ends of the conductive interconnects 314. In other words, the semiconductor die 102 and the conductive interconnects 314 are sandwiched between the front-side routing structures 316 and the back-side routing structure 366. In some embodiments, the back-side routing structure 366 is electrically connected to the semiconductor die 102 by the conductive interconnects 314 and the front-side routing structure 316. In some embodiments, sidewalls 312E of the molding compound 312 are leveled with corresponding sidewalls 316E of the front-side routing structure 316 and corresponding sidewalls 366E of the back-side routing structure 366. Therefore, the sidewalls 312E of the molding compound 312, the sidewalls 316E of the front-side routing structure 316 and the sidewalls 366E of the back-side routing structure 366 may collectively serve as package sidewalls of the bottom package 300A (e.g., opposite sidewalls 300S1 and 300S3 of the bottom package 300A shown in FIG. 1).

The conductive elements 322 are in contact with and electrically connected to the front-side routing structure 316. In addition, the conductive elements 322 are electrically connected to the base 200. In some embodiments, the conductive elements 322 includes a conductive ball structure such as a copper ball, a conductive bump structure such as a copper bump or a solder bump structure, or a conductive pillar structure such as a copper pillar structure. For example, the conductive elements 322 may be controlled collapse chip connection (C4) structures composed of conductive pillar structures and conductive bump structures.

In some embodiments, the back-side routing structure 366 includes a redistribution layer (RDL) structure or an interposer. For example, the back-side routing structure 366 may be an interposer 366. In some embodiments, the back-side routing structure 366 includes one or more conductive traces 369, one or more vias 368 disposed in one or more dielectric layers 367 and contact pads 370. In some embodiments, the material of the conductive traces 369 and the contact pads 370 may be similar to the material of the conductive traces 319 and the contact pads 320. The material of the vias 368 may be similar to the material of the vias 318. In addition, the material of the dielectric layers 367 may be similar to the material of the dielectric layers 317. It should be noted that the number of dielectric layers 367, that the number of vias 368, the number of conductive traces 369 and the number of contact pads 370 shown in FIG. 1 are only an example and are not a limitation to the present disclosure.

As shown in FIG. 1, the top package 400 is mounted on the bottom package 300A by conductive elements 422 using a bonding process. In addition, the conductive elements 422 are in contact with the back-side routing structure 366. As shown in FIG. 2, the top package 400 may have a rectangular plan-view shape. The top package 400 may have opposite edges 400S1 and 400S3 extending substantially along the direction 100 and opposite edges 400S2 and 400S4 substantially along the direction 110. In some embodiments, the top package 400 includes a memory package. For example, the top package 400 includes a dynamic random access memory (DRAM) package or another applicable memory package. In some embodiments, the top package 400 includes a substrate 418, at least one semiconductor die, for example, two semiconductor dies 402 and 404 that are stacked on the substrate 418, and the conductive elements 422. In some embodiments, each of the semiconductor dies 402 and 404 comprises a dynamic random access memory (DRAM) die (e.g., a double data rate 4 (DDR4) DRAM die, a low-power DDR4 (LPDDR4) DRAM die), synchronous dynamic random access memory (SDRAM) die or the like) or another applicable memory die. In some other embodiments, the semiconductor dies 402 and 404 may comprise the same or different devices. In some embodiments, the top package 400 also includes one or more passive components (not illustrated), such as resistors, capacitors, inductors, the like, or a combination thereof.

In this embodiment, as shown in FIG. 1, there are two semiconductor dies 402 and 404 mounted on the substrate 418 by a paste (not shown). The semiconductor dies 402 and 404 have corresponding pads 408 and 410 thereon. The pads 408 and 410 of the semiconductor dies 402 and 404 may be electrically connected to the substrate 418 using the respective bonding wires 414 and 416. However, the number of stacked semiconductor dies is not limited to the disclosed embodiment. Alternatively, the semiconductor dies 402 and 404 as shown in FIG. 1 may be arranged side by side and mounted on the substrate 418 by a paste (not shown). Alternatively, the semiconductor dies 402 and 404 may be fabricated by a flip-chip technology and electrically connected to the substrate 418 without using the bonding wires 414 and 416.

As shown in FIG. 1, the substrate 418 may comprise vias 428 and contact pads 420 and 430 disposed in one or more extra-low K (ELK) and/or ultra-low K (ULK) dielectric layers (not shown). The contact pads 420 are disposed on the tops of the vias 428 close to a top surface (die-attach surface) 418T of the substrate 418. In addition, the bonding wires 414 and 416 are electrically connected to the corresponding contact pads 420. The contact pads 430 are disposed on the bottoms of the vias 428 close to a bottom surface (bump-attach surface) 418B of the substrate 418. The contact pads 430 may be located directly under or not directly under the vias 428. The contact pads 430 are electrically connected to the corresponding contact pads 420. In some embodiments, the bonding wires 414 and 416, the contact pads 420 and 430 and the vias 428 include a conductive material, such as metals comprising copper, gold, silver, or other applicable metals.

In some embodiments, as shown in FIG. 1, the memory package 400 further includes a molding material 412 covering the top surface (die-attach surface) 418T of the substrate 418 and the semiconductor dies 402 and 404. In addition, the molding material 412 may encapsulate the semiconductor dies 402 and 404 and the bonding wires 414 and 416. The top surface of the molding material 412 may serve as a top surface 400T of the top package 400. As shown in FIG. 1, the molding material 412 of the top package 400 may be separated from the molding compound 312 of the bottom package 300A by the conductive elements 422. In some embodiments, the molding materials 312 and 412 may include the same or similar materials and fabrication processes.

FIG. 2 also shows the position of the conductive structures 422 of the top package 400 stacked on the bottom package 300A. For illustration, the dashed line is used to show the position of the bottom package 300A. As shown in FIG. 1, the conductive structures 422 are disposed on the bottom surface 418B of substrate 418 opposite the semiconductor dies 402 and 404. The conductive structures 422 are electrically connected to (or in contact with) the corresponding contact pads 430 of the substrate 418 and the back-side routing structure 366. In some embodiments, the conductive structures 422 of the top package 400 (e.g. the DRAM package) are arranged according the given arrangement. As shown in FIG. 2, the conductive structures 422 of the top package 400 are arranged in multi-columns along the directions 100 and 110. In some embodiments, the conductive structures 422 may be arranged according to the standards for the data rates of DDR. For example, the distribution region of the conductive structures 422 may have a hollow square shape.

As shown in FIG. 2, the position of the conductive structures 422 may keep in the center regions of the top package 400 and the bottom package 300A. In some embodiments, conductive structures 422 overlap the bottom package 300A. In some embodiments, the conductive structures 422 include a conductive ball structure such as a copper ball, a conductive bump structure such as a copper bump or a solder bump structure, or a conductive pillar structure such as a copper pillar structure.

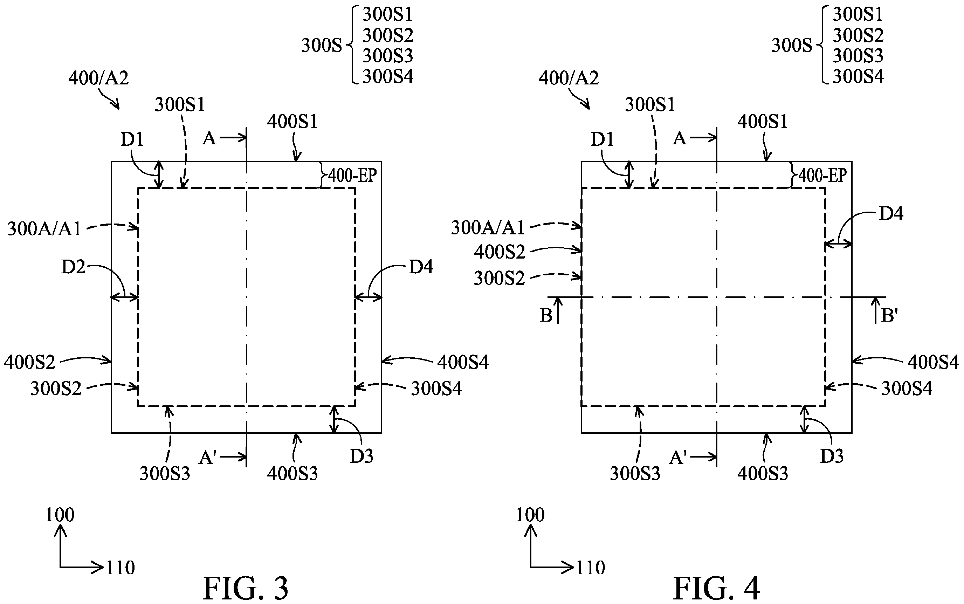

FIGS. 3, 4, 5 and 6 are plan views of the top package 400 stacked and the bottom package 300A of the semiconductor device 500A of FIG. 1 in accordance with some embodiments of the disclosure, showing the relative position between the top package 400 stacked on the bottom package 300A. It is noted that FIGS. 3, 4, 5 and 6 only show the edges 400S1 to 400S4 of the top package 400 and sidewall of the bottom package 300A for illustration, the remaining features may be shown in the schematic cross-sectional view of FIG. 1. In addition, FIG. 1 may also serve as the cross-sectional view taken along the line A-A' of the semiconductor device 500A shown in FIGS. 3, 4, 5 and 6. In some embodiments, the top package 400 has at least one portion 400-EP protrudes from sidewalls 300S (including the sidewalls 300S1, 300S2, 300S3 and 300S4) of the bottom package 300A. As shown in FIGS. 3, 4, 5 and 6, the bottom package 300A may have a rectangular plan-view shape. The bottom package 300A may have opposite sidewalls 300S1 and 300S3 extending substantially along the direction 100 and opposite sidewalls 300S2 and 300S4 substantially along the direction 110. In some embodiments, as shown in FIG. 3, the edge 400S1 of the top package 400 extends outward beyond the sidewall 300S1 of the bottom package 300A with a distance D1 in the direction 110, the edge 400S2 of the top package 400 extends outward beyond the sidewall 300S2 of the bottom package 300A with a distance D2 in the direction 100, the edge 400S3 of the top package 400 extends outward beyond the sidewall 300S3 of the bottom package 300A with a distance D3 in the direction 110, and the edge 400S4 of the top package 400 extends outward beyond the sidewall 300S4 of the bottom package 300A with a distance D4 in the direction 100. In some embodiments, the distances D1, D2, D3 and D4 may all be unequal, or at least two of them may be equal. In some embodiments, as shown in FIG. 4, the edge 400S1 of the top package 400 extends outward beyond the sidewall 300S 1 of the bottom package 300A with a distance D1 in the direction 110, the edge 400S2 of the top package 400 may be flush with the sidewall 300S2 of the bottom package 300A in the direction 100, the edge 400S3 of the top package 400 extends outward beyond the sidewall 300S3 of the bottom package 300A with a distance D3 in the direction 110, and the edge 400S4 of the top package 400 extends outward beyond the sidewall 300S4 of the bottom package 300A with a distance D4 in the direction 100. In some embodiments, the distances D1, D3, and D4 may all be unequal, or at least two of them may be equal. The above designs can enhance flexibility and provide more options to accommodate different application scenarios.

In some embodiments, the top package 400 may completely cover the bottom package 300A in a top view as shown in FIGS. 3 and 4. Therefore, the semiconductor device 500A as shown in FIGS. 3 and 4 may be also called the fully-overhang type semiconductor device 500A, and the top package 400 completely blocks bottom package 300A, and no portion of bottom package 300A is exposed from top package 400 in the top view. For example, as shown in FIGS. 1 and 3, the portion 400-EP may protrude from and surround four sidewalls 300S1, 300S2, 300S3 and 300S4 of the bottom package 300A. For example, as shown in FIGS. 1 and 4, the portion 400-EP may protrude from three sidewalls 300S1, 300S3 and 300S4 of the bottom package 300A. In some embodiments, the fully-overhang type semiconductor device 500A may maintain a smaller bottom package size and improve design flexibility. Therefore, the fabrication cost of the bottom package 300A may be reduced. In addition, the base 200 may provide an additional area 200R for component placement, as shown in FIG. 1.

As shown in FIGS. 3 and 4, the bottom package 300A may have a first area A1 and the top package 400 has a second area A2 greater than the first area A1. In some embodiments, a ratio of the difference between the first area A1 and second area A2 to the first area A1 is greater than 0 and less than or equal to 0.56. If the ratio is greater than 0.56, the vertical projection (along the direction 120) of the center of mass of the top package 400 may be located outside of the bottom package 300A in the top view. The semiconductor device 500A may have unbalanced mass distributions and suffer the mounting stability of the top package 400.

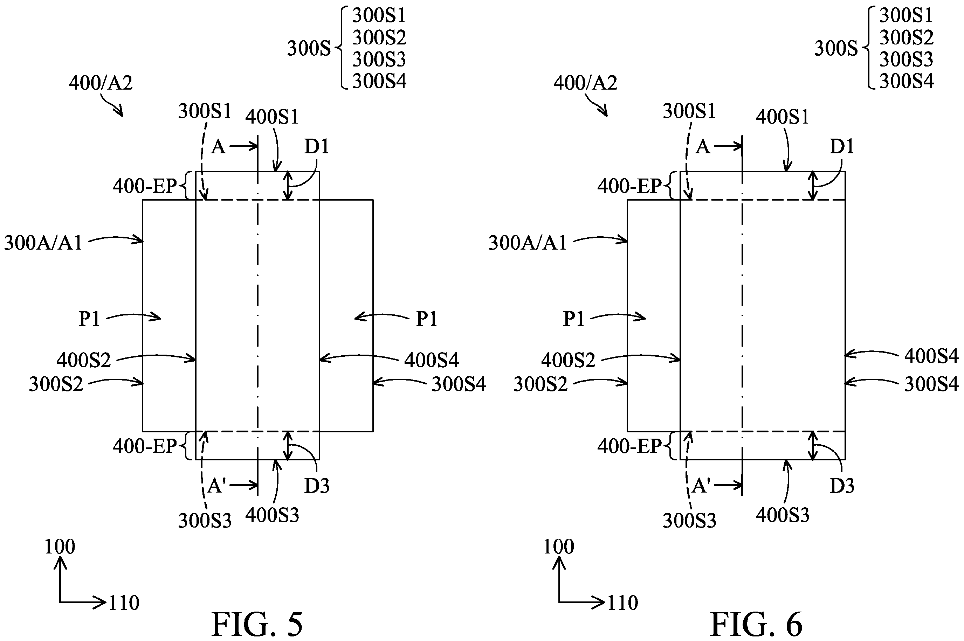

In some embodiments, the top package 400 may partially cover the bottom package 300A and have at least one portion 400-EP protruding from the sidewalls 300S of the bottom package 300A in a top view as shown in FIG. 5 or FIG. 6. Therefore, the semiconductor device 500A as shown in FIGS. 5 and 6 may be also called the partial-overhang type semiconductor device 500A. For example, as shown in FIGS. 1, 5 and 6, the portion 400-EP may protrude from and surround two sidewalls 300S1 and 300S3 of the bottom package 300A. In some embodiments, the bottom package 300A may have one or more portions P1 exposed from the top package 400 in the top view. For example, there are two portions P1 of the bottom package 300A, which are respectively close to the sidewalls 300S2 and 300S4, are exposed from the top package 400 in the top view as shown in FIG. 5. For example, there is one portion P1 of the bottom package 300A, which is close to the sidewall 300S2, are exposed from the top package 400 in the top view as shown in FIG. 6. It is noted that the number and the position of the portion P1 of the bottom package 300A exposed from the top package 400 are not limited to the disclosed embodiment. In some embodiments, as shown in FIG. 5, the edge 400S1 of the top package 400 extends outward beyond the sidewall 300S1 of the bottom package 300A with a distance D1 in the direction 110, the sidewall 300S2 of the bottom package 300A extends outward beyond the edge 400S2 of the top package 400 in the direction 100, the edge 400S3 of the top package 400 extends outward beyond the sidewall 300S3 of the bottom package 300A with a distance D3 in the direction 110, and the sidewall 300S4 of the bottom package 300A extends outward beyond the edge 400S4 of the top package 400 in the direction 100. In some embodiments, the distances D1 and D3 may be equal or unequal. In some embodiments, as shown in FIG. 6, the edge 400S1 of the top package 400 extends outward beyond the sidewall 300S1 of the bottom package 300A with a distance D1 in the direction 110, the sidewall 300S2 of the bottom package 300A extends outward beyond the edge 400S2 of the top package 400 in the direction 100, the edge 400S3 of the top package 400 extends outward beyond the sidewall 300S3 of the bottom package 300A with a distance D3 in the direction 110, and the edge 400S4 of the top package 400 may be flush with the sidewall 300S4 of the bottom package 300A in the direction 100. In some embodiments, the distances D1 and D3 may be equal or unequal. The above designs can enhance flexibility and provide more options to accommodate different application scenarios.

In some embodiments, the partial-overhang type semiconductor device 500A may be adapted to the top packages 400 in different sizes and improve design flexibility. For example, the second area A2 of top packages 400 may be greater than, the same as or smaller than the first area A1 of the bottom package 300A.

As shown in FIGS. 3, 4, 5 and 6, in some embodiments, each of the distances D1, D2, D3, D4 of the portion 400-EP that protrudes from the sidewall 300S of the bottom package 300A is greater than 0 and less than or equal to 5 mm. If the distances D1, D2, D3, D4 are greater than 5 mm, the top package 400 may have a poor mounting stability.

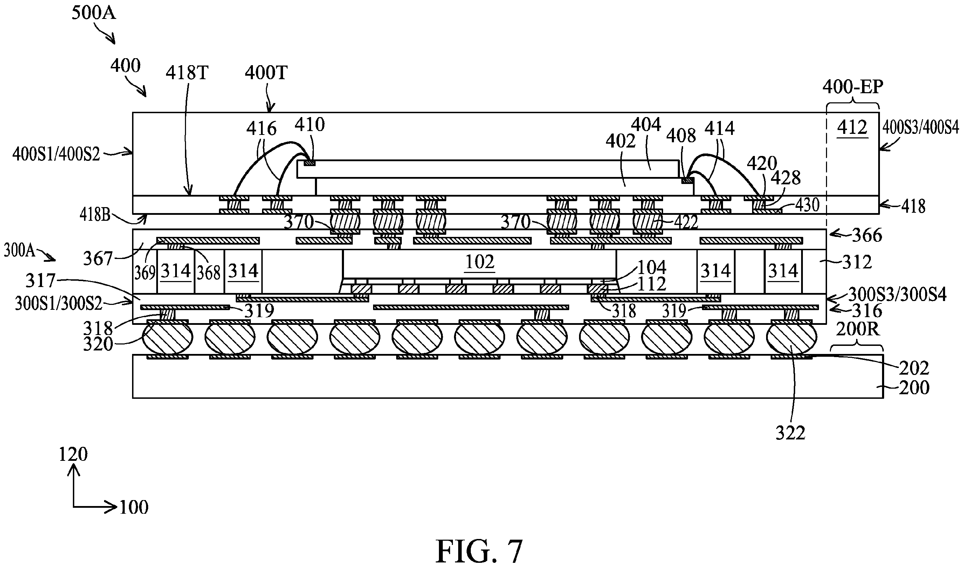

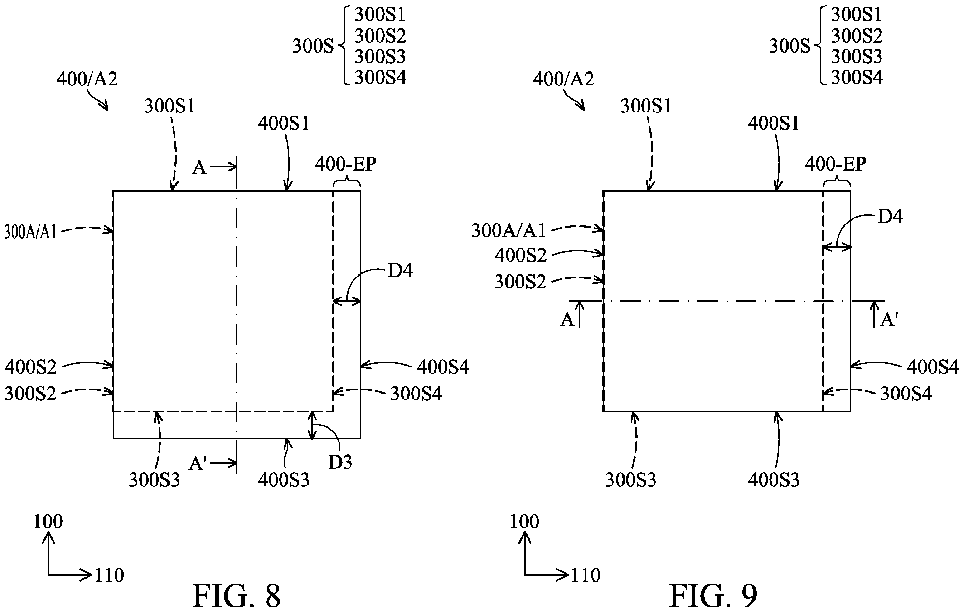

In some embodiments, the top package 400 of the fully-overhang type semiconductor device 500A may have at least one edge flush with the corresponding sidewall of the bottom package. FIG. 7 is a cross-sectional view of the semiconductor device 500A in accordance with some embodiments of the disclosure. FIGS. 8 and 9 are perspective bottom views of the semiconductor device 500A of FIG. 7 in accordance with some embodiments of the disclosure, showing the relative position between the top package 400 stacked on the bottom package 300A. FIG. 4 may also serve as the perspective bottom view of the semiconductor device 500A of FIG. 7. In addition, FIG. 7 may also serve as the cross-sectional view taken along the line A-A' of the semiconductor device 500A shown in FIGS. 8, and 9 and taken along the line B-B' of the semiconductor device 500A shown in FIG. 4. Elements of the embodiments hereinafter, that are the same or similar as those previously described with reference to FIGS. 1 to 6, are not repeated for brevity.

For example, as shown in FIGS. 4 and 7, one edge 400S2 of the top package 400 may be flush with the corresponding sidewall 300S2 of the bottom package 300A. For example, as shown in FIGS. 4 and 8, two edges 400S1 and 400S2 of the top package 400 may be flush with the corresponding sidewalls 300S1 and 300S2 of the bottom package 300A. For example, as shown in FIGS. 4 and 9, three edges 400S 1, 400S2 and 400S3 of the top package 400 may be flush with the corresponding sidewalls 300S1, 300S2 and 300S3 of the bottom package 300A.

Similarly, in some embodiments as shown in FIGS. 8 and 9, a ratio of the difference between the first area A1 and second area A2 to the first area A1 is greater than 0 and less than or equal to 0.56. In addition, distances D3 and D4 of the portion 400-EP that protrudes from the sidewall 300S of the bottom package 300A may be greater than 0 and less than or equal to 5 mm.

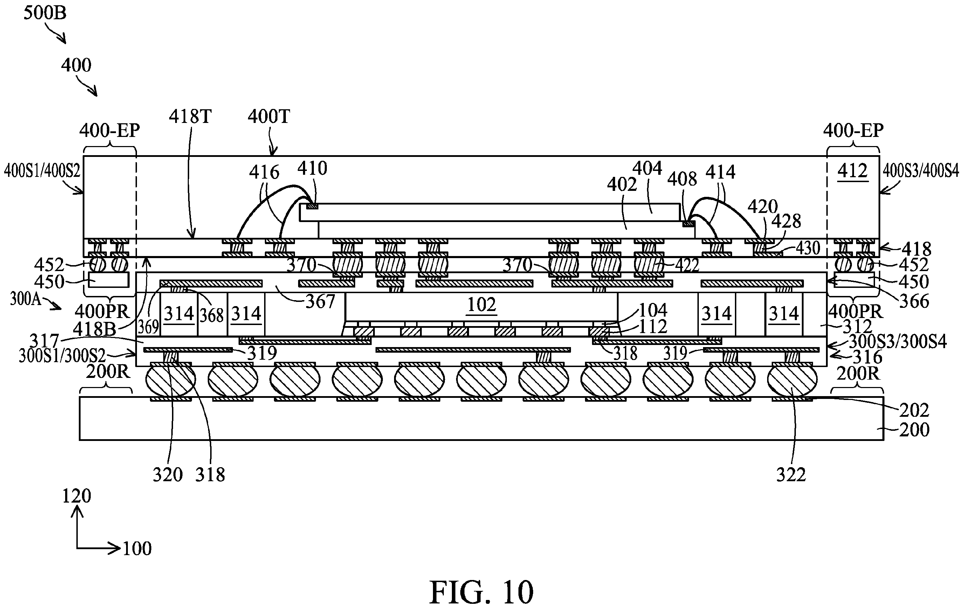

In some embodiments, the portion of the top package protrudes from the sidewall of the bottom package may provide an additional area for electronic component disposed on it. FIG. 10 is a cross-sectional view of a semiconductor device 500B in accordance with some embodiments of the disclosure. Elements of the embodiments hereinafter, that are the same or similar to those previously described with reference to FIGS. 1 to 9, are not repeated for brevity.

One of the differences between the semiconductor device 500A and the semiconductor device 500B is that the semiconductor device 500B further includes at least one passive device 450. In some embodiments, the passive device 450 may be mounted on a protruding region 400PR of the portion 400-EP of the top package 400. In addition, the protruding region 400PR may be located on a portion of the bottom surface 418B of the substrate 418 of the top package 400. In some embodiments, the passive device 450 and the bottom package 300A are arranged side-by-side and disposed on the same side of the top package 400. For example, the passive device 450 and the bottom package 300A are arranged side-by-side and disposed on the bottom surface 418B of the substrate 418 of the top package 400, and the passive device 450 is disposed adjacent to the respective sidewall (such as the sidewall 300S3/300S4) of the bottom package 300A. In addition, the passive device 450 and the bottom package 300A are separate from each other. Furthermore, the passive device 450 and the bottom package 300A are electrically connected to the top package 400 by different conductive elements. For example, the bottom package 300A is electrically connected to the top package 400 by conductive elements 422. The passive device 450 is electrically connected to the top package 400 by conductive elements 452 different form the conductive elements 422. In addition, the passive device 450 may be arranged outside the distribution area of the conductive structures 422. For example, the passive device 450 may be mounted on protruding region 400PR close to any of the edges 400S 1, 400S2, 400S3 and 400S4. Furthermore, the passive device 450 does not have to be covered by a molding compound. In some embodiments, the passive device 450 includes a capacitor, an inductor, a resistor, or a combination thereof. For example, the passive device 450 may be a land-side capacitor (LSC) including a multilayer ceramic capacitor (MLCC), a silicon capacitor or another applicable capacitor.

In some embodiments, the conductive elements 422 and 452 may include the same or similar materials and structures. In addition, the size and pitch of the conductive elements 452 may be the same as or different from the conductive elements 422. For example, the size and pitch of the conductive elements 452 may be smaller than those of the conductive elements 422.

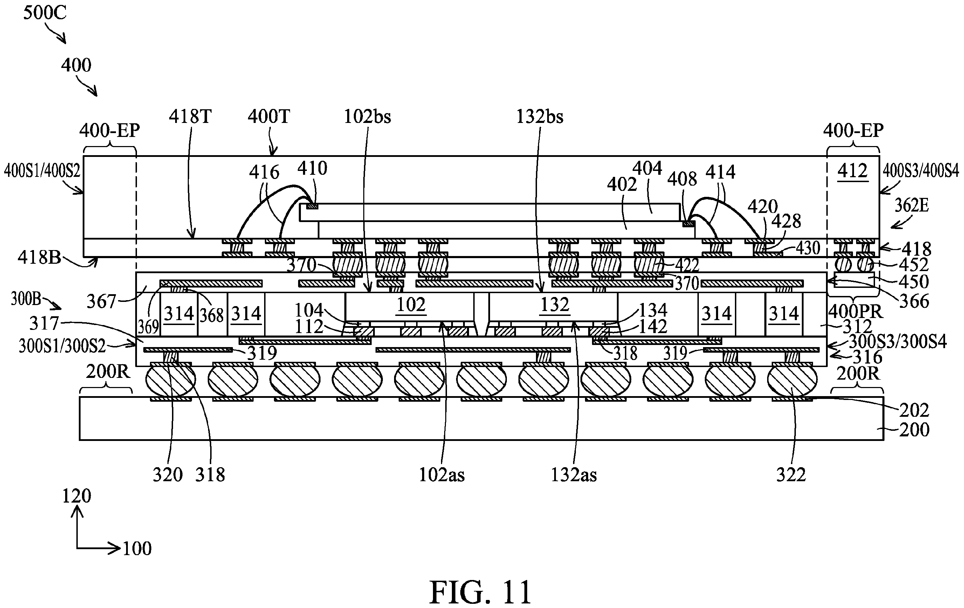

In some embodiments, the bottom package of the semiconductor device may include various types to improve design flexibility, as described in more detail below. FIG. 11 is a cross-sectional view of a semiconductor device 500C in accordance with some embodiments of the disclosure. Elements of the embodiments hereinafter, that are the same or similar as those previously described with reference to FIGS. 1 to 10, are not repeated for brevity. In some embodiments, the semiconductor device 500C includes the top package 400 and a bottom package 300B. In addition, the bottom package 300B may include a multi-die package.

As shown in FIG. 11, the bottom package 300B includes at least two semiconductor dies, for example, the semiconductor dies 102 and 132 arranged side-by-side along the direction 100. The semiconductor dies 102 and 132 are disposed between the front-side routing structure 316 and the back-side routing structure 366. The semiconductor die 132 has an active surface 132as and a backside surface 132bs opposite to the active surface 132as. In some embodiments, the semiconductor dies 102 and 132 are fabricated by using a flip-chip technology. The semiconductor dies 102 and 132 may be flipped to be disposed on the front-side routing structure 316 opposite the conductive structures 322. Pads 104 and 134 on the active surface 102as of the semiconductor die 102 and the active surface 132as of the semiconductor die 132 are electrically connected to the front-side routing structure 316 using conductive elements 112 and 142. The semiconductor dies 102 and 132 are electrically connected to the base 200 using the vias 318, the conductive traces 319 and the contact pads 320 of the front-side routing structure 316 and the corresponding conductive elements 322. In some embodiments, the semiconductor die 132 is electrically connected to the semiconductor die 102 only using the vias 318 and the conductive traces 319 inside the front-side routing structure 316. In some embodiments, the semiconductor dies 102 and 132 each independently includes a system-on-chip (SOC) die, a logic device, a memory device, a radio frequency (RF) device, the like, or any combination thereof. For example, the semiconductor dies 102 and 132 may each independently include a micro control unit (MCU) die, a microprocessor unit (MPU) die, a power management integrated circuit (PMIC) die, a global positioning system (GPS) device, a central processing unit (CPU) die, a graphics processing unit (GPU) die, an input-output (IO) die, a dynamic random access memory (DRAM) IP core, a static random-access memory (SRAM), a high bandwidth memory (HBM), the like, or any combination thereof. In some embodiments, the semiconductor dies 102 and 132 have different functions. In some embodiments, the semiconductor dies 102 and 132 are fabricated in different technology nodes.

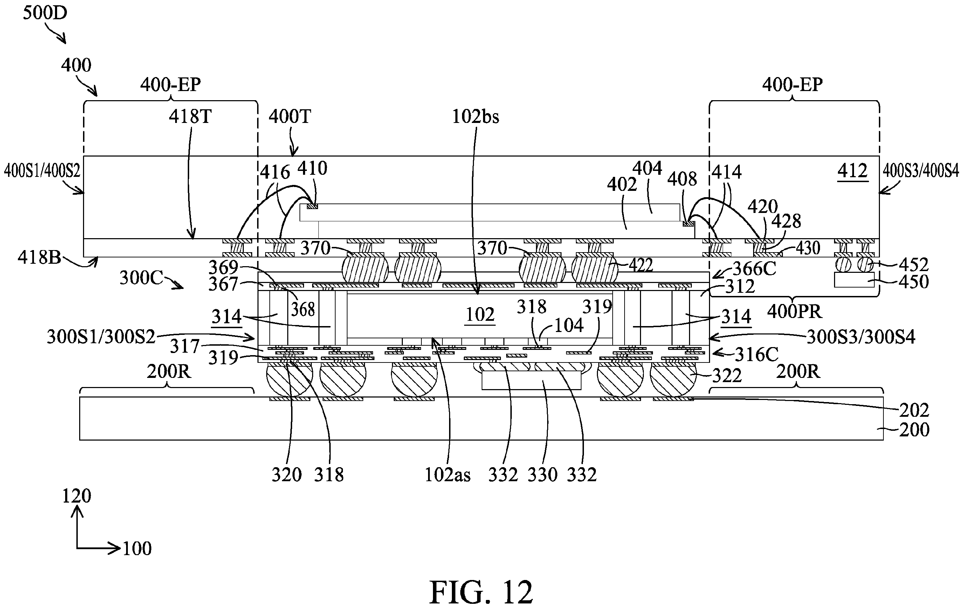

FIG. 12 is a cross-sectional view of a semiconductor device 500D in accordance with some embodiments of the disclosure. Elements of the embodiments hereinafter, that are the same or similar to those previously described with reference to FIGS. 1 to 11, are not repeated for brevity. In some embodiments, the semiconductor device 500D may be a fan-out package-on-package (fan-out POP). The semiconductor device 500D includes the top package 400 and a bottom package 300C. In addition, the bottom package 300C may include a front-side routing structure 316C and a back-side routing structure 366C disposed on the active surface 102as and the backside surface 102bs of the semiconductor die 102. In some embodiments, the front-side routing structure 316C is a front-side RDL structure 316C, and the back-side routing structure 366C is a back-side RDL structure 366C. In some embodiments, the front-side RDL structure 316C and the back-side RDL structure 366C may include one or more conductive traces (not shown), one or more vias (not shown) disposed in one or more dielectric layers (not shown). In some embodiments, the conductive elements 322 are electrically connected to and in contact with the front-side RDL structure 316C, the conductive elements 422 are electrically connected to and in contact with the back-side RDL structure 366C.

As shown in FIG. 12, the bottom package 300C may further include an electronic component 330 mounted on the front-side routing structure 316C opposite the semiconductor die 102. In some embodiments, the electronic component 330 has pads 332 on it and is electrically connected to the conductive traces 319 of the front-side routing structure 316C. In some embodiments, the electronic component 330 is arranged between the conductive structures 322. The electronic component 330 does not have to be covered by a molding compound. In some embodiments, the electronic component 330 comprises integrated passive device (IPD) including a capacitor, an inductor, a resistor, or a combination thereof. For example, the electronic component 330 may be a land-side capacitor (LSC) including a multilayer ceramic capacitor (MLCC), a silicon capacitor or another applicable capacitor.

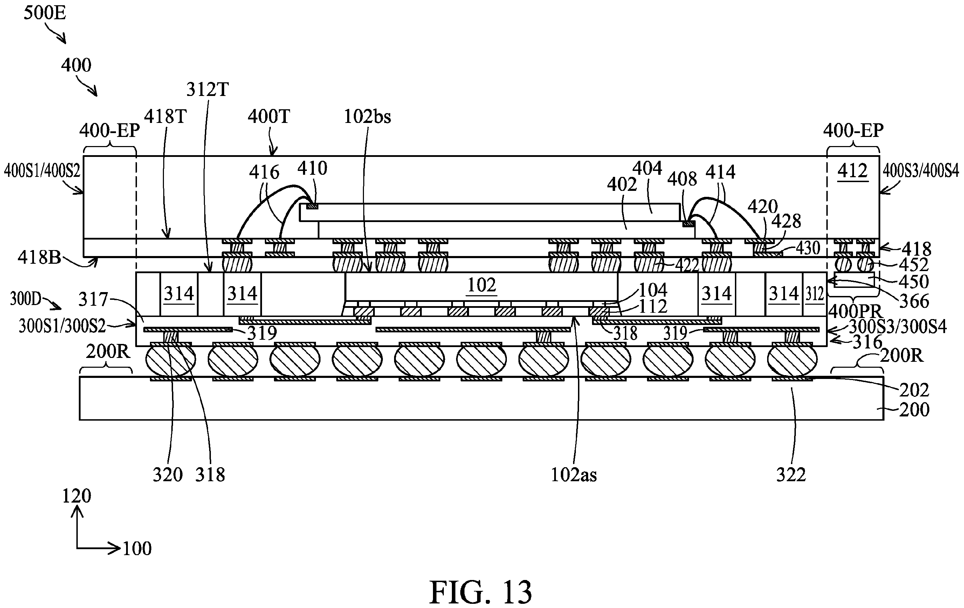

FIG. 13 is a cross-sectional view of a semiconductor device 500D in accordance with some embodiments of the disclosure. Elements of the embodiments hereinafter, that are the same or similar as those previously described with reference to FIGS. 1 to 12, are not repeated for brevity. One of the differences between the semiconductor device 500B and the semiconductor device 500E is that a bottom package 300D of the semiconductor device 500E is fabricated without the back-side routing structure 366. Therefore, a top surface 312T of the molding compound 312 may serve as a top surface 312T of the bottom package 300D. In addition, the ends of the conductive interconnects 314 close to the top package 400 may be exposed to the top surface 312T of the molding compound 312. In some embodiments, the conductive elements 422 are in contact with the corresponding conductive interconnects 314.

It is noted that FIGS. 10 to 13 only show the cross-sectional views of the semiconductor device 500B, 500C, 500D and 500E for illustration. It is appreciated that although some features are shown in some embodiments but not in other embodiments, these features may (or may not) exist in other embodiments whenever possible. For example, although each of the illustrated example embodiments of FIGS. 3-6, 8 and 9 shows specific arrangements of the relative position between the top package 400 and the bottom package 300A of the semiconductor device 500A of FIGS. 1 and 7, any other combinations of the arrangements of the relative position between the top package 400 and the bottom package 300A may also be used in the arrangements of the relative position between the top package 400 and the bottom package 300B/300C/300D of the semiconductor device 500B/500C/500D/500E of FIGS. 10-13 whenever applicable.

Embodiments provide a semiconductor device such as a package-on-package (PoP) semiconductor package. The semiconductor device includes a bottom package and a top package. The bottom package is mounted on a base. The top package is mounted on the bottom package. In some embodiments, at least one portion of the top package protrudes from the sidewall of the bottom package. In other words, the top package may have at least one overhanging portion. In some embodiments, the semiconductor device in which the top package completely covers the bottom package may be called the fully-overhang type semiconductor device. The fully-overhang type semiconductor device may keep the bottom package in a small size and improve design flexibility. Therefore, the fabrication cost of the bottom package may be reduced. In addition, the base may have more available area for component placement. In some embodiments, the top package may partially cover the bottom package. Therefore, the semiconductor device in which the top package partially covers the bottom package may be called the partial-overhang type semiconductor device. The partial-overhang type semiconductor device can be adapted to the top packages in different sizes and improve design flexibility. In some embodiments, the overhanging portion of the top package may provide additional areas for passive component placement. In some embodiments, the bottom package may have various types. Therefore, the fabricated semiconductor device may have different types, such as a high bandwidth package-on-package (HBPoP) package or a fan-out package-on-package (fan-out PoP) package, to improve design flexibly.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. A semiconductor device, comprising:
   a bottom package; and
   a top package mounted on the bottom package;
   wherein at least one portion of the top package protrudes from a sidewall of the bottom package.
2. The semiconductor device as claimed in clause 1, wherein a distance of the at least one portion that protrudes from the sidewall of the bottom package is greater than 0 mm and less than or equal to 5 mm.
3. The semiconductor device as claimed in clause 1, wherein the top package completely covers the bottom package in a top view.
4. The semiconductor device as claimed in clause 3, wherein at least one edge of the top package is flush with the corresponding sidewall of the bottom package.
5. The semiconductor device as claimed in clause 1, wherein the top package partially covers the bottom package in a top view.
6. The semiconductor device as claimed in clause 5, wherein a first portion of the bottom package is exposed from the top package in a top view.
7. The semiconductor device as claimed in clause 1, further comprising:
   a passive device mounted on a protruding region of the at least one portion of the top package.
8. The semiconductor device as claimed in clause 7, wherein the passive device and the bottom package are arranged side-by-side and disposed on the same side of the top package.
9. The semiconductor device as claimed in clause 7, wherein the passive device and the bottom package are electrically connected to the top package by different conductive elements.
10. The semiconductor device as claimed in clause 1, wherein in a top view, the bottom package has a first area and the top package has a second area greater than the first area, and wherein a ratio of the difference between the first and second areas to the first area is greater than 0 and less than or equal to 0.56.
11. The semiconductor device as claimed in clause 1, wherein the bottom package comprises a routing structure located between the top package and a first semiconductor die of the bottom package.
12. The semiconductor device as claimed in clause 11, wherein the semiconductor device is a high bandwidth package-on-package (HBPOP) package or a fan-out package-on-package (fan-out POP) package.
13. The semiconductor device as claimed in clause 11, wherein the top package is mounted on the bottom package using first conductive elements, and the first conductive elements are in contact with the routing structure.
14. The semiconductor device as claimed in clause 1, wherein the top package is mounted on the bottom package using first conductive elements, wherein the bottom package comprises conductive interconnects surrounding at least one first semiconductor die of the bottom package, and wherein the first conductive elements are in contact with the respective conductive interconnects.
15. The semiconductor device as claimed in clause 14, wherein the bottom package comprises a first molding compound covering the first semiconductor die, wherein the conductive interconnects pass through the first molding compound.
16. A semiconductor device, comprising:
   a bottom package; and
   a top package mounted on the bottom package;
   wherein at least one edge of the top package extends outward beyond a respective sidewall of the bottom package.
17. The semiconductor device as claimed in clause 16, wherein the at least one edge of the top package extends outward beyond the respective sidewall of the bottom package with a distance, wherein the distance is greater than 0 mm and less than or equal to 5 mm.
18. The semiconductor device as claimed in clause 16, wherein the top package partially covers the bottom package, or the top package completely covers the bottom package.
19. The semiconductor device as claimed in clause 16, wherein the bottom package has a first area and the top package has a second area greater than the first area, and wherein a ratio of the difference between the first and second areas to the first area is greater than 0 and less than or equal to 0.56.
20. The semiconductor device as claimed in clause 16, further comprising:
   a passive device mounted on an extending portion of the top package, wherein the passive device is disposed adjacent to the respective sidewall of the bottom package.

## Claims

1. A semiconductor device (500A, 500B, 500C, 500D, 500E), comprising:
a bottom package (300, 300A, 300B, 300C, 300D); and
a top package (400) mounted on the bottom package (300, 300A, 300B, 300C, 300D);
wherein at least one portion (400-EP) of the top package (400) protrudes from a sidewall (300S, 300S1, 300S2, 300S3, 300S4, 312E, 316E, 366E) of the bottom package (300, 300A, 300B, 300C, 300D).

2. The semiconductor device (500A, 500B, 500C, 500D, 500E) as claimed in claim 1, wherein a distance of the at least one portion (400-EP) that protrudes from the sidewall (300S, 300S1, 300S2, 300S3, 300S4, 312E, 316E, 366E) of the bottom package (300, 300A, 300B, 300C, 300D) is greater than 0 mm and less than or equal to 5 mm.

3. The semiconductor device (500A, 500B, 500C, 500D, 500E) as claimed in claim 1, wherein the top package (400) completely covers the bottom package (300, 300A, 300B, 300C, 300D) in a top view.

4. The semiconductor device (500A, 500B, 500C, 500D, 500E) as claimed in claim 3, wherein at least one edge (400S1, 400S2, 400S3, 400S4) of the top package (400) is flush with the corresponding sidewall (300S, 300S1, 300S2, 300S3, 300S4, 312E, 316E, 366E) of the bottom package (300, 300A, 300B, 300C, 300D).

5. The semiconductor device (500A, 500B, 500C, 500D, 500E) as claimed in claim 1, wherein the top package (400) partially covers the bottom package (300, 300A, 300B, 300C, 300D) in a top view.

6. The semiconductor device (500A, 500B, 500C, 500D, 500E) as claimed in claim 5, wherein a first portion (400-EP) of the bottom package (300, 300A, 300B, 300C, 300D) is exposed from the top package (400) in a top view.

7. The semiconductor device (500A, 500B, 500C, 500D, 500E) as claimed in claim 1, further comprising:
a passive device (450) mounted on a protruding region (400PR) of the at least one portion (400-EP) of the top package (400).

8. The semiconductor device (500A, 500B, 500C, 500D, 500E) as claimed in claim 7, wherein the passive device (450) and the bottom package (300, 300A, 300B, 300C, 300D) are arranged side-by-side and disposed on the same side of the top package (400).

9. The semiconductor device (500A, 500B, 500C, 500D, 500E) as claimed in claim 7, wherein the passive device (450) and the bottom package (300, 300A, 300B, 300C, 300D) are electrically connected to the top package (400) by different conductive elements (422, 452).

10. The semiconductor device (500A, 500B, 500C, 500D, 500E) as claimed in claim 1, wherein in a top view, the bottom package (300, 300A, 300B, 300C, 300D) has a first area and the top package (400) has a second area greater than the first area, and wherein a ratio of the difference between the first and second areas to the first area is greater than 0 and less than or equal to 0.56.

11. The semiconductor device (500A, 500B, 500C, 500D, 500E) as claimed in any one of the claims 1-10, wherein the bottom package (300, 300A, 300B, 300C, 300D) comprises a routing structure (366) located between the top package (400) and a first semiconductor die (102, 132) of the bottom package (300, 300A, 300B, 300C, 300D).

12. The semiconductor device (500A, 500B, 500C, 500D, 500E) as claimed in claim 11, wherein the semiconductor device (500A, 500B, 500C, 500D, 500E) is a high bandwidth package-on-package, HBPoP, package or a fan-out package-on-package, fan-out PoP, package.

13. The semiconductor device (500A, 500B, 500C, 500D, 500E) as claimed in claim 11, wherein the top package (400) is mounted on the bottom package (300, 300A, 300B, 300C, 300D) using first conductive elements (422), and the first conductive elements (422) are in contact with the routing structure (366).

14. The semiconductor device (500A, 500B, 500C, 500D, 500E) as claimed in claim 1, wherein the top package (400) is mounted on the bottom package (300, 300A, 300B, 300C, 300D) using first conductive elements (422), wherein the bottom package (300, 300A, 300B, 300C, 300D) comprises conductive interconnects (314) surrounding at least one first semiconductor die (102, 132) of the bottom package (300, 300A, 300B, 300C, 300D), and wherein the first conductive elements (422) are in contact with the respective conductive interconnects (314).

15. The semiconductor device (500A, 500B, 500C, 500D, 500E) as claimed in claim 14, wherein the bottom package (300, 300A, 300B, 300C, 300D) comprises a first molding compound (312) covering the first semiconductor die (102, 132), wherein the conductive interconnects (314) pass through the first molding compound (312).
